Europäisches Patentamt

European Patent Office

Office européen des brevets

(11) Publication number: **0 416 171 A2**

# EUROPEAN PATENT APPLICATION

(21) Application number: **89123572.3**

(51) Int. Cl.5: **G01R 31/00**

(22) Date of filing: **20.12.89**

(30) Priority: **04.09.89 JP 228490/89**

(43) Date of publication of application:
**13.03.91 Bulletin 91/11**

(84) Designated Contracting States:
**DE FR GB**

(71) Applicant: **NIPPON YUSOKI CO.,LTD**
**No. 1-1, Higashi-Kotari 2-chome**
**Nagaokakyo-shi Kyoto(JP)**

(72) Inventor: **Makino, Noriaki**
**No. 1485-1 Oogi-cho**
**Ootsu-shi Shiga(JP)**

(74) Representative: **Patentanwälte Grünecker,**
**Kinkeldey, Stockmair & Partner**
**Maximilianstrasse 58**
**W-8000 München 22(DE)**

(54) **Monitor display method in electric vehicle.**

(57) A monitor display method in an electric vehicle comprises displaying groups monitoring spots in pictorial symbols on a display unit, a management information message during a normal operation and an abnormal information message during an abnormal operation. The method also comprises storing in a memory the names of abnormal parts judged from self-diagnosis as history data and displaying the history data on the display unit when setting a history data display mode. The method further comprises effecting arithmetic by the microcomputer on receiving switch signals, sensor signals and feedback signals, exhibiting a normal display mode when a select switch is in a predetermined position and an I/O condition display mode when the select switch is in other positions, and displaying the I/O port register data in numerals of 1 or 0, characters or symbols.

## FIG. 1

EP 0 416 171 A2

# MONITOR DISPLAY METHOD IN ELECTRIC VEHICLE

## BACKGROUND OF THE INVENTION

The present invention relates to a monitor display method of displaying, on a display unit, pieces of monitor information both on inspection and on supervision, history data on abnormal parts and equipments, and of checkup information associated with microcomputer control in an electric vehicle equipped with a microcomputer.

A conventional method of displaying the monitor information on the inspection/monitoring spots in the electrically-driven vehicle involves the use of units depicted in FIGS. 7 to 9 in view of simplification of the construction and considering economical advantages.

Illustrated in FIG. 7 is a display unit having a plurality of LEDs 101, arrayed in parallel, for indicating a battery residual capacity. The battery residual capacity is indicated by the number of the LEDs lit up. A display mode of the unit shown in FIG. 8 is that pictures and characters are printed on a cover 102 of a lamp box, and a monitor result is indicated by lightening a built-in lamp in the pictures and characters thus printed. The unit depicted in FIG. 9 performs a segment display 103 intended to give a recognition of a display content through a numeral-to-content exchange table, the arrangement being such that the numerals displayed substitute for a message by giving a significance thereto.

A so-called machine-to-man interface has hitherto been constructed by use of the above-described display units. There are, however, caused the following drawbacks to this configuration.

A judgment as to the battery residual capacity depends on the number of the LEDs light up to merely have a simplex display function, as a result of which a set of data on variations in control corresponding to the residual capacity can not be recognized.

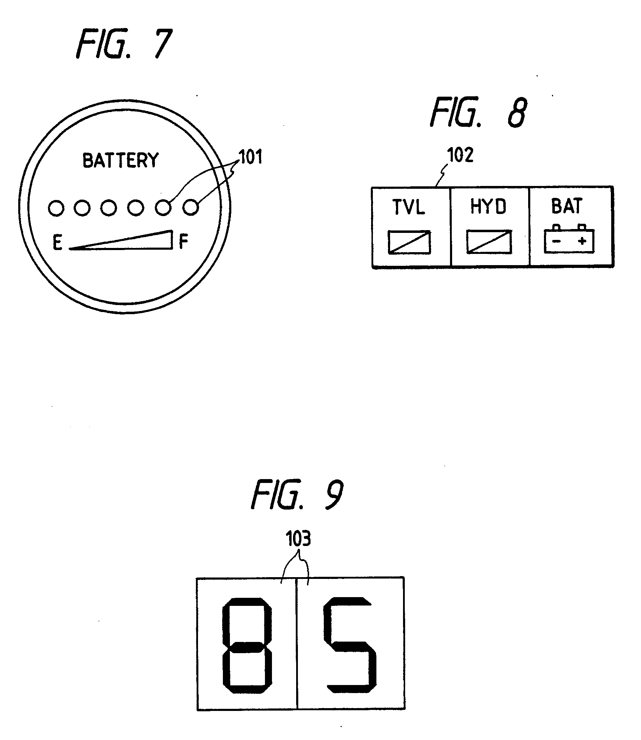

In a monitor display mode by use of the lamp shown in FIG. 8, there is given only the simplex display function relative to a monitoring target, and hence classification in detail requires a good number of monitor lamp boxes.

A segment display mode illustrated in FIG. 9 has such an advantage that a variety of display contents are expressible. This mode also has disadvantages in which the display contents are not understandable without referring to the exchange table for relating the signified contents to the numerals, so that the unit functions as an indirect interface display unit alone. Besides, the conventional display systems are nothing but combinations of individual display units in design. This brings about an intricacy of system configuration, which in turn hinders a quick understanding of the operator of an electrically-driven vehicle, e.g., a battery-driven forklift.

Moreover, in a control system invested with a function to self-diagnose the parts and units of the electric vehicle, it is a common practice to exhibit a name of the part or the unit which has proven to be abnormal at that time as a result of the self-diagnosis. As a matter of fact, however, there is hardly prevailed at all a method of storing the name of the abnormal part into an internal memory and effecting a checkup for confirmation by invoking the data stored therein as the necessity arises some other days.

The reasons for this will be elucidated as follows:

Firstly, a typical dominant idea is that there is no problem if the present conditions remain normal. Hence, the necessity for knowing the fact that presently well-conditioned parts had encountered the abnormality in the past is not yet understood.

Secondly, even if the data are stored in the internal memory, the system is mounted with no adequate display unit for displaying the stored data. For instance, the results of self-diagnosis are typically indicated by means of an alarm lamp of the monitor. Exemplifying a hydraulic fuse as an abnormal component, the abnormal state of a hydraulic system as a whole is known by the fact that the alarm lamp in the hydraulic system is merely lit up or flickered. There is provided no display unit for informing the conditions of a multiplicity of parts in the hydraulic system. For this reason, even if some faults in the hydraulic system including the parts that were in the abnormal state in the past are displayed later as history data, the data are almost insignificant. It is because the history data do not contain specific names of the abnormal parts. Eventually, this implies that such history data do not deserve the display.

It is not easy to check the control over a microcomputer for controlling the display system described above, so that the following methods have hitherto been used.

The first method will be explained as below. There are prepared tools such as an emulator and a debugger, or a dedicated checker and a dedicated analyzer. The function of a processor unit within a microcomputer of the electric vehicle is stopped. Instead, an alternate processor incorporated in the tool behaves to actuate the microcomputer of the electric vehicle. Bus data and control signals of the alternate processor are taken in the took and I/O data of the microcomputer in the electric vehicle are displayed on the display unit like a CRT set in the tool, thus checking I/O conditions of the microcomputer thereof.

The second method will next be described. When preparing no such full-scale tool, a meter or a general purpose measuring instrument such as a synchroscope is provided as a substitute. A probe input terminal is connected to a terminal of an I/O port of the microcomputer of the electric vehicle for a checkup with the intention of measuring voltages and waveforms thereof. The I/O conditions of the microcomputer of the electric vehicle are thus checked.

The third method will hereinafter be explained. Assuming that economical and spatial advantages are of no importance, the I/O conditions can be checked with facility by attaching LEDs to the respective terminals of the I/O port of the microcomputer of the electric vehicle. A sequencer conceived as an applied product of the microcomputer is applicable to this instance.

The I/O conditions of the microcomputer has heretofore been checked on the basis of the first to third methods discussed above. There exist, however, the following disadvantages inherent in these prior art methods.

Based on the first method, the full-scale tool is needed, and hence a specialized engineer for the tool is, although it has an advantage of making practicable an elaborate checkup, required, because it is difficult for a general service or maintenance man to handle the tool. In addition, the first method is remarkably costly, which does not match the reality.

The second method is not costly, because an easily available measuring instrument and meter suffice for use. However, it is still difficult for the general service or maintenance man to connect the probe input terminal to the I/O port terminal in the microcomputer mother board. More specifically, it takes a good deal of labors to seek out patterns of the microcomputer mother board and effect the connection to the measuring instrument. If short-circuit mistakenly happens between the patterns adjacent to each other or between the terminals, there is a probability that the mother board thereof are secondarily deteriorated.

In accordance with the third method, the ordinary service or maintenance man is able to perform the checkup. However, a multiplicity of LEDs are mounted, and hence a packaging space increases, resulting in an increment in power supply capacity. This in turn entails a countermeasure against thermal dispersion. In general, the third method is hard to be adopted in terms of economical and spatial advantages.

## SUMMARY OF THE INVENTION

It is an object of this invention to eliminate the above-mentioned difficulties with the conventional monitor display method.

It is another object of this invention to provide a monitor display method in an electric vehicle, which is capable of displaying detailed messages and pieces of monitor result information on a multiplicity of inspecting/monitoring spots so as to be easily and directly understood, in which particularly the display is combined with pictures to facilitate the understanding of a driver to considerably reduce mental burdens thereon.

It is a further object of this invention to provide a monitor display method of displaying history data about abnormal parts in an electric vehicle, which is capable of recording abnormality generation data so that the parts of transient abnormality are readily detectable, scientific sagety management in terms of a grand total can be performed, and the safety management of the electric vehicle can be carried out with a high reliability.

It is a still further object of this invention to provide a monitor display method of in an electric vehicle incorporating both a microcomputer-based control system and a display system for displaying pieces of management information and of monitor information on the respective components of the electric vehicle, which is capable of displaying, using the display system, the data contents of a register of an I/O port of the microcomputer when checking the operation of the microcomputer, so as to improve in economy and maintenance inspection, and to easily detect the cause of the accident when the operation of the computer control system is abnormal.

According to this invention, in a monitor system including a control means and a display unit for effecting monitor-display, concentrating pieces of monitor information on a plurality of inspecting/monitoring spots at a sigle place in an electric vehicle, the monitor display method comprising the steps of: dividing a variety of monitoring spots into groups according to every functional component of the electric vehicle; displaying these groups of monitoring spots in the form of pictorial symbols on the display unit; indicating monitor resuots in the pictorial symbols; and displaying a management information message in character, etc., during a normal operation of the electric vehicle and a detailed abnormal information message in character etc., for every pictorial symbol indication associated with the respective monitoring spots during an abnormal operation thereof, respectively.

Also, according to this invention, in a control system having a self-diagnostic function for parts and equipments of an electric vehicle and also incorporating a display unit for displaying the self-diagnostic results, a monitor display method comprises the steps of: sequentially storing in an internal memory the names of the parts of equipments as history data for abnormal parts which are judged to be abnormal from the self-diagnostic results in the order of the abnormalities being caused; setting a mode of displaying the abnormal part history data; and displaying the abnormal part history data on the display unit in the order of the abnormalities being caused or in the reversed order in the form of character messages or codes when setting the foregoing mode.

In this control system of this invention, the monitor display method is characterized as follows: The display unit employed, which is capable of making expressions by a plurality of bits in parallel, has a mode of displaying the abnormal part history data, and the names of the parts or equipments which are judged abnormal from the self-diagnostic results are stored in the internal memory. When setting the foregoing mode, the individual bits of the display unit are made to correspond to the respective parts. Displayed on the display unit are active signals marked with [1] or [H] with respect to the bits corresponding to the abnormal parts and non-active signals marked with [O] or [L] with respect to the bits corresponding to the normal parts.

Based on the method of the second invention, the names of the parts of equipments which are judged abnormal by the self-diagnostic function of the control system are stored in the internal memory in the order of the abnormalities being caused to thereby create the abnormal part history data. It is possible to display the history data in the abnormality generating order or reversely back from the latest data on the display unit by setting the data display mode.

In accordance with the monitor display method mentioned thirdly, the names of the parts or equipments which are judged abnormal are stored in the internal memory to thereby create the abnormal part history data. When setting the data display mode, the plurality of parallel bits of the display unit are made to correspond to the individual parts. Displayed on the display unit are the active signals associated with the bits corresponding to the abnormal parts and the non-active signals associated with the bits corresponding to the normal parts.

Further, according to this invention, in an electric vehicle incorporating both a microcomputer-based control system and a display system for displaying pieces of management information and of monitor information on the respective components of the electric vehicle by outputs of the control system, there is provided a monitor display method comprising: permitting the microcomputer to effect an arithmetic operation on the basis of input data upon inputting signals from operation switches and sensors of the respective components of the electric vehicle or feedback signals of the individual components; outputting control output signals or display signals; exhibiting a normal display mode when a selecting state of mode change-over select switch attached to the microcomputer is in a predetermined position; displaying general information on the control or arithmetic results on a display unit; exhibiting an I/O condition display mode when the selecting state of the select switch is in positions other than the predetermined one; and displaying on the display unit the data contents, in the form of numerals such as 1 or 0, characters or symbols, of a register of an I/O port of the microcomputer, which contents correspond to the selecting positions.

When observing the contents of the I/O data of the microcomputer during the normal control, the I/O conditions can immediately be displayed simply by properly changing over the selecting positions of the select switch while effecting the normal control.

## BRIEF DESCRIPTION OF THE DRAWINGS

Other objects and advantages of the present invention will become more apparent during the following discussion taken in conjunction with the accompanying drawings, in which:

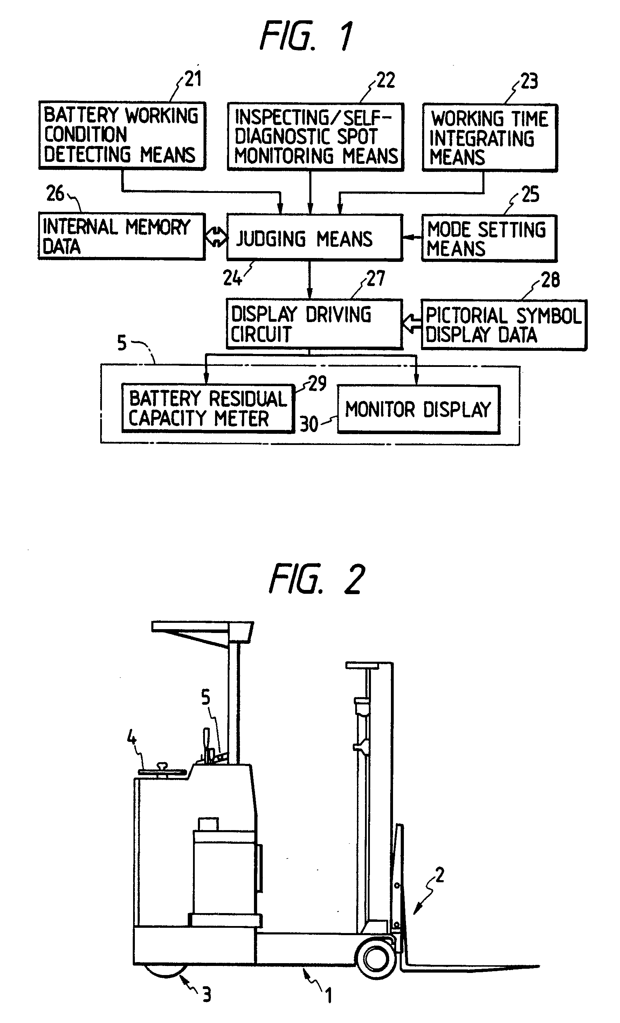

FIG. 1 is a block diagram illustrating fundamental function components of a system for carrying out a monitor display method of the present invention;

FIG. 2 is a side elevation depicting a battery forklift mounted with the above-mentioned system;

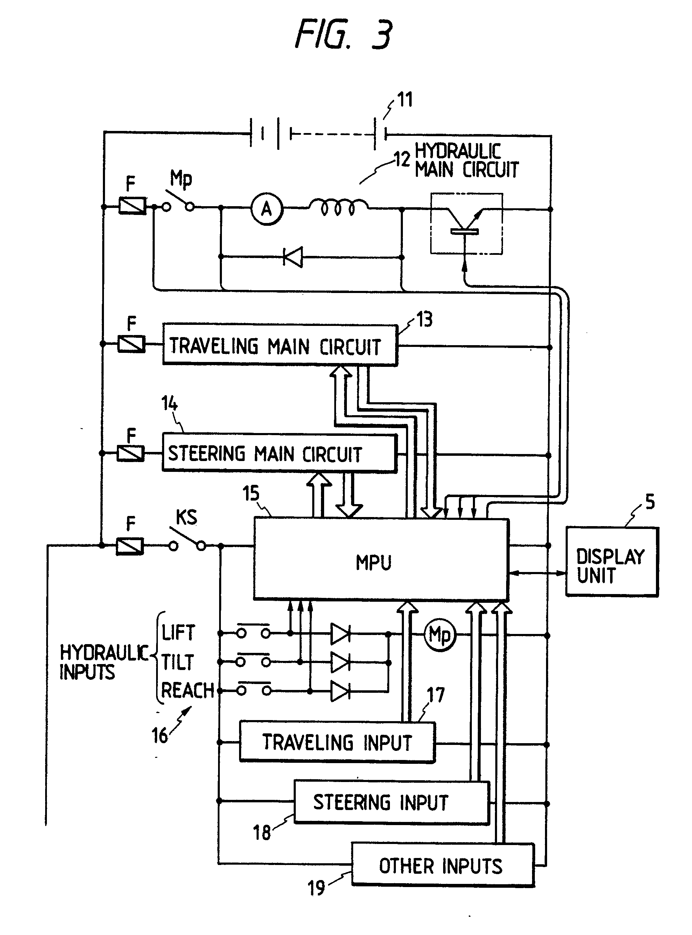

FIG. 3 is a diagram showing a circuitry of an electric circuit of the system;

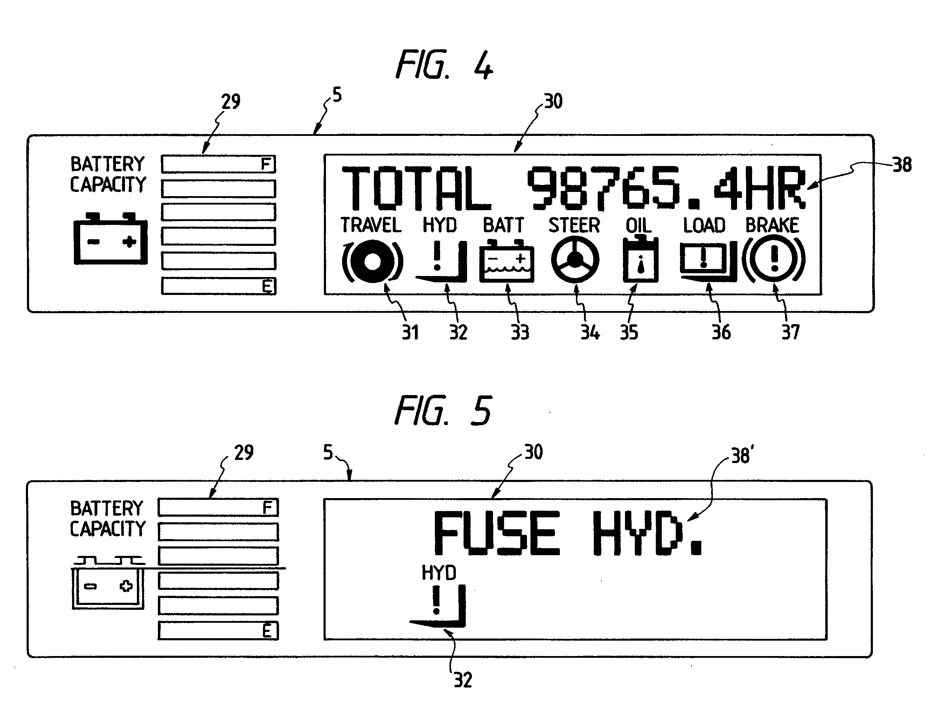

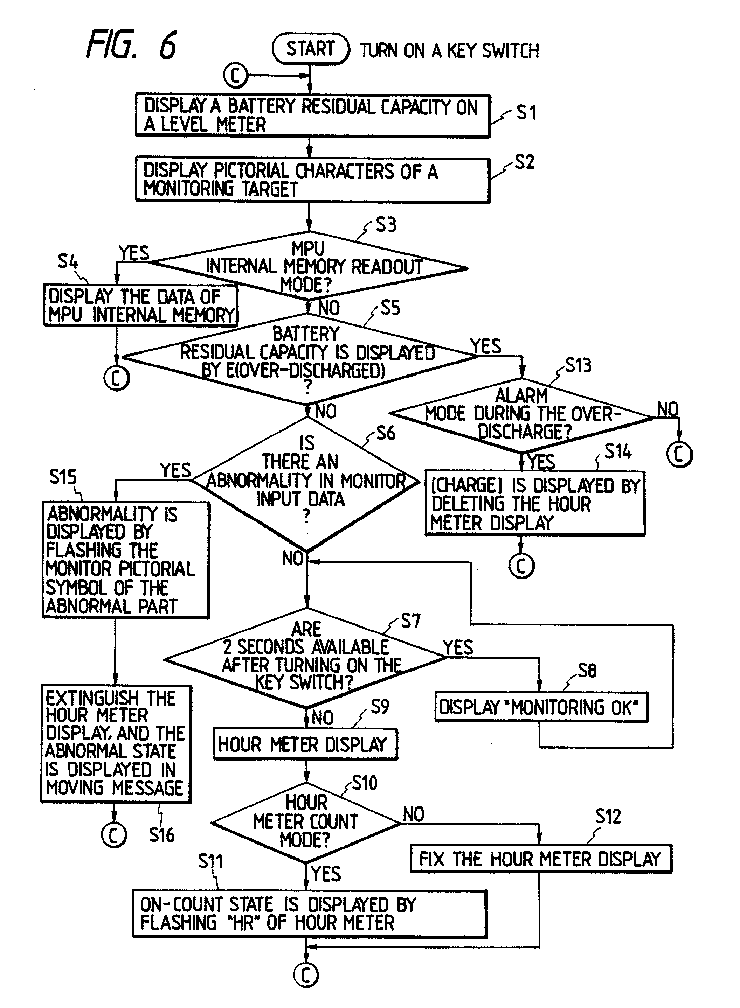

FIGS. 4 and 5 are diagrams each illustrating a variety of display modes of a display unit of the system;

FIG. 6 is a flowchart of assistance in explaining operations of the system;

FIGS. 7 through 9 are diagrams showing examples of conventional display modes;

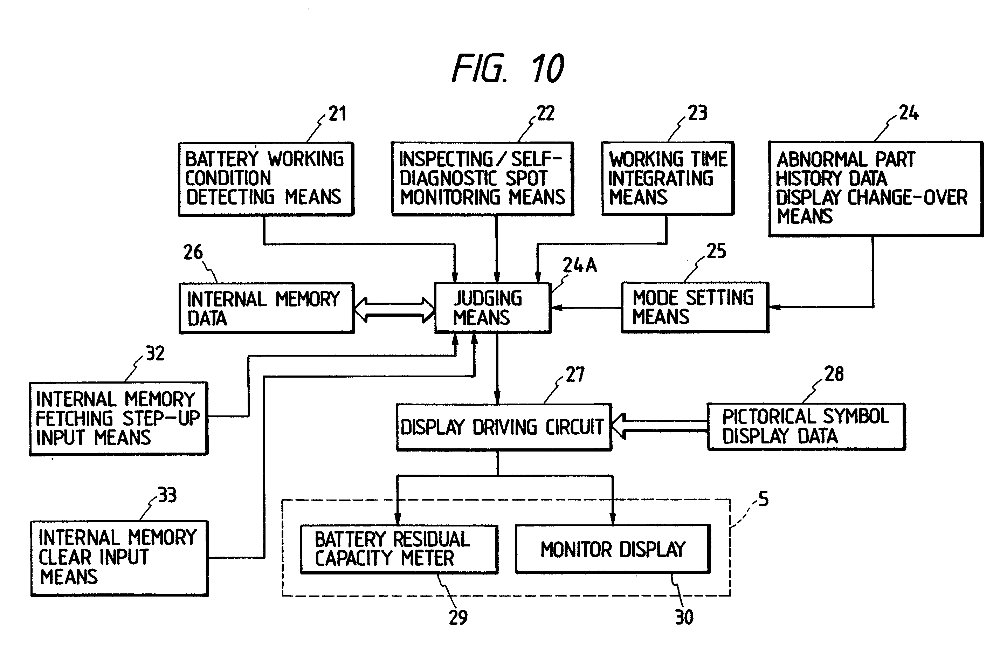

FIG. 10 is a block diagram of fundamental function components of a system for displaying abnormal part history data, showing one example of the monitor display method of the invention;

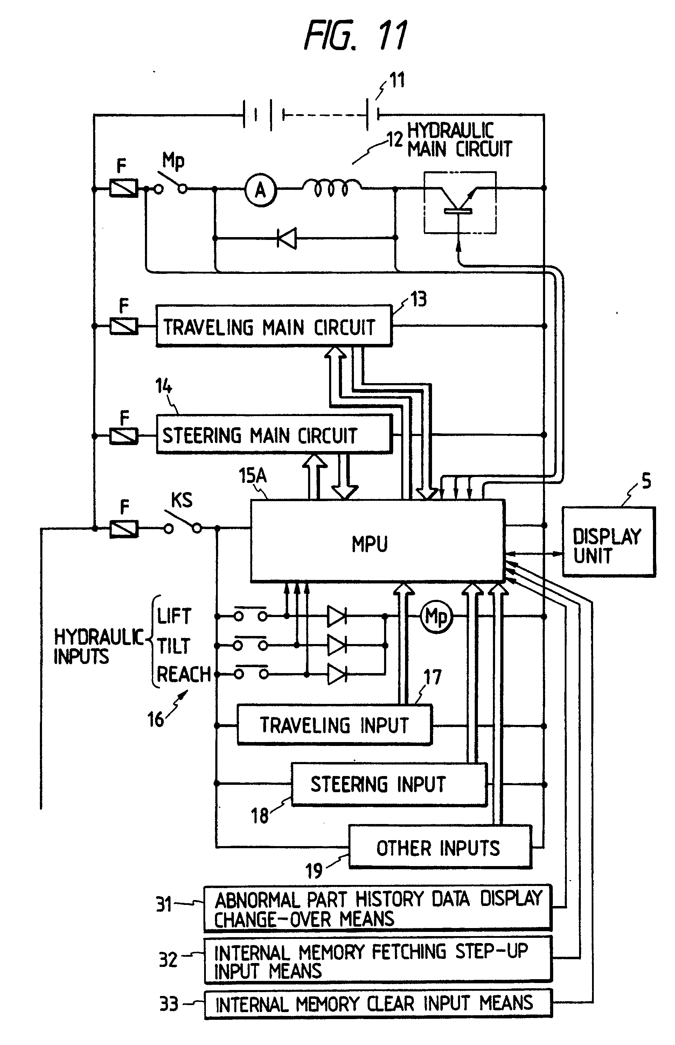

FIG. 11 is a diagram depicting a circuitry of an electric circuit of the system;

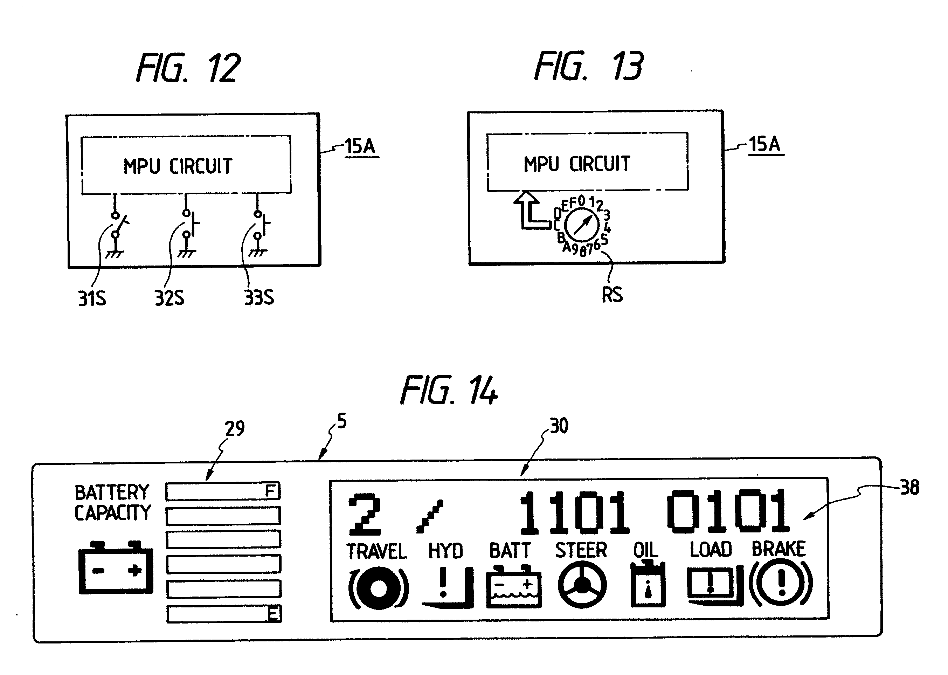

FIGS. 12 and 13 are block diagrams each depicting an input means to a microcomputer 15A of the system;

FIG. 14 is a diagram showing an example of display mode of the display unit;

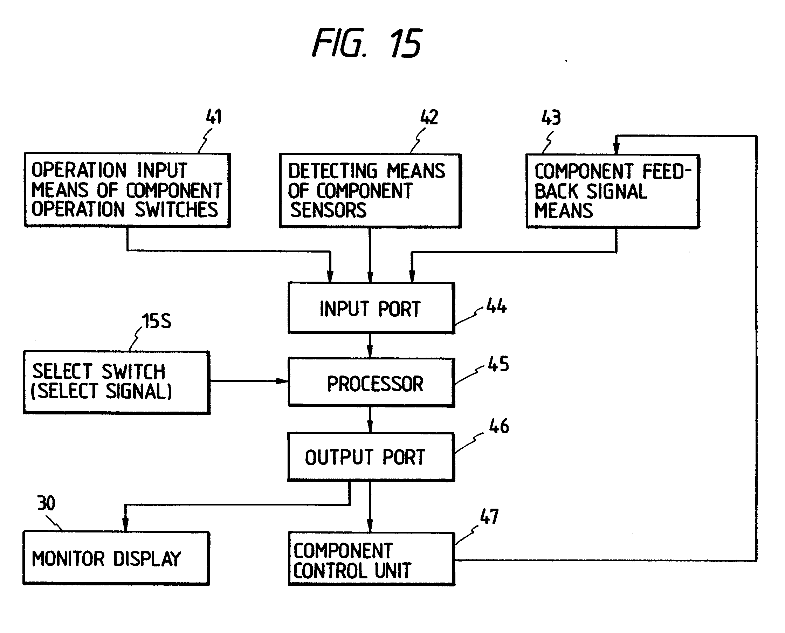

FIG. 15 is a block diagram of fundamental function components of a system for displaying the I/O conditions, showing one example of the monitor display method of the invention;

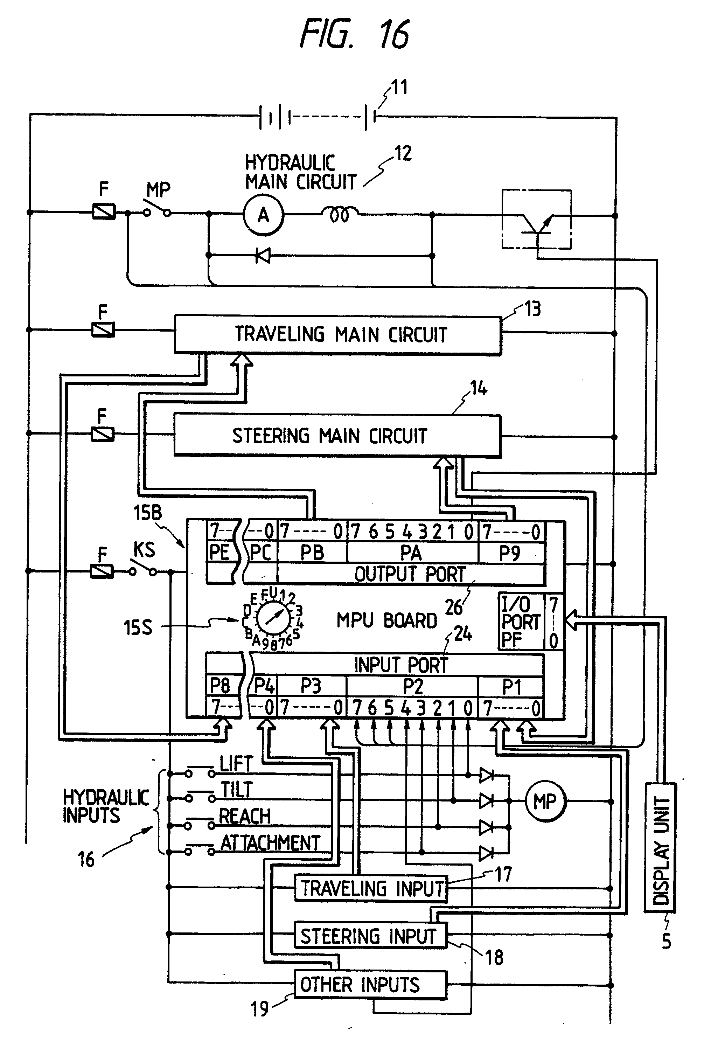

FIG. 16 is a diagram illustrating a circuitry of an electric circuit of the system; and

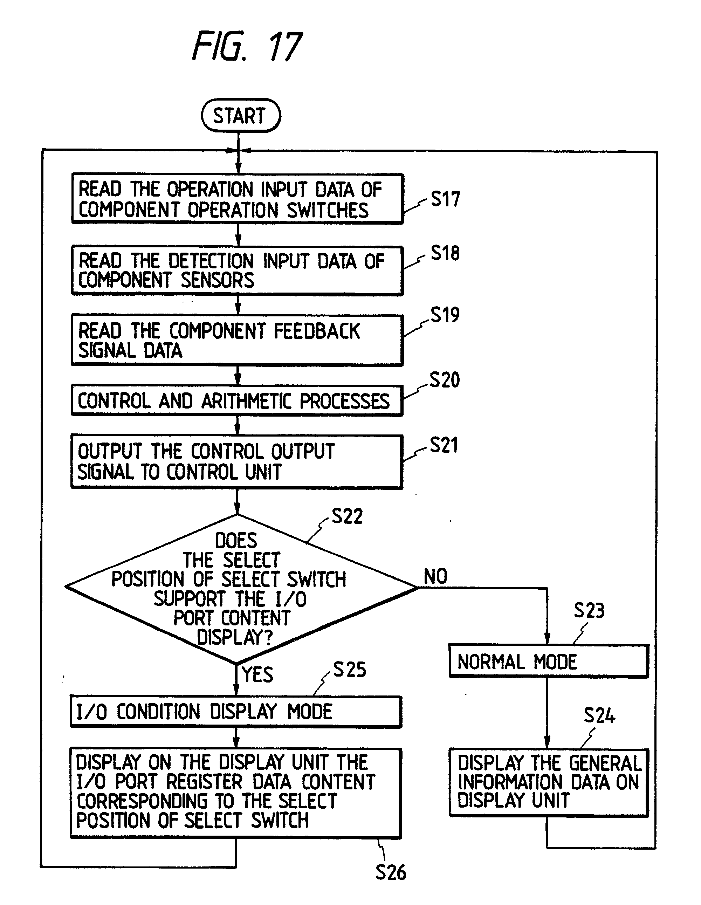

FIG. 17 is a flowchart of assistance in explaining operations of the system.

## DETAILED DESCRIPTION OF THE PREFERRED EMBODIMENTS

Turning first to FIG. 2, there is illustrated a battery-driven forklift (hereinafter referred to as a battery forklift) as one example of an electrically driven vehicle mounted with a system for carrying out a monitor display method according to the present invention.

In FIG. 2, numeral reference 1 represents a vehicle body; 2 a fork which hydraulically performs raising, lowering tilting and reaching operations; 3 a traveling wheel; 4 a steering handle; and 5 a display unit for displaying monitor information. The vehicle body 1 incorporates a hydraulic circuit including an unillustrated battery and hydraulic motor and also a control circuit including a microcomputer (MPU).

FIG. 3 shows circuitry of the hydraulic circuit and the control circuit of the battery forklift.

Referring to FIG. 3, numeral reference 11 designates a battery; 12 a hydraulic main circuit for raising and lowering the forklift; 13 a traveling main circuit; 14 a steering main circuit; 15 a microcomputer composed of a micro-processing unit (MPU); 16 a input unit for performing hydraulic inputs (to lift, tilt and reach the fork); 17 a traveling input unit; 18 a steering input unit; and 19 an input unit for other components.

Indicated by MP is a relay or a contact thereof for turning ON/OFF the hydraulic main circuit. The reference symbol KS denotes a key switch ; and F a fuse for keeping safety when anomalous currents flow in the respective circuits.

The microcomputer 15 receives multiple inputs to control actuators such as the hydraulic main circuit 12, the traveling main circuit 13 and the steering main circuit 14. The microcomputer 15 also behaves, as will be mentioned later, to monitor and check situations of the actuators, each working time thereof and a voltage of the battery 11 in accordance with predetermined programs. Subsequently, the microcomputer 15 causes the monitor contents and the management information messages to be displayed on the display unit 5.

FIG. 5 is a block diagram depicting a functional construction based on the microcomputer 15. Referring to FIG. 1, numeral 21 reference stands for a battery working condition detecting means; 22 an inspecting/self-diagnosis spot monitoring means associated with the hydraulic main circuit 12; 23 a working time integrating means; 24 a judging means for performing the self-diagnosis as to whether or not the above-described means are in a normal operating state upon receiving monitor signals therefrom and further other judgments; 25 a mode setting means which will hereinafter be stated; 26 internal memory data for control; 27 a display driving circuit to which signals are outputted on the basis of self-diagnostic results given from the judging means 24; 28 pictorial symbol display data for pictorial-symbol-displaying a variety of monitoring spots which have already been grouped according to every functional component of the battery forklift; 29 a battery residual capacity meter of the display unit 5 which will be noted later; and 30 a monitor display.

Turning to FIG. 4, there is illustrated a specific construction of the display unit. FIG. 4 shows a normal display mode. The battery residual capacity meter 29 is constructed as a level meter employing a plurality of LEDs, the monitor display 30 is composed of an LCD. Seven pieces of pictorial symbols 31 to 37 arrayed in a lower line thereof indicates respective groups of the monitoring spots necessary for the daily inspections and at every operating time of the battery forklift, these spots being divided according to every functional component. A character representation 38, which is given in an upper line thereof and consisting of Japanese characters, alphabetic characters and numerals that are formed in dot matrices, exhibits, in addition to an integrated working time (hour meter), a detailed information message such as a name of the abnormal part for every pictorial symbol when the abnormal state is confirmed from the self-diagnostic results.

Referring to FIG. 5, there is illustrated a display mode of the display unit when an abnormal state is detected by the self-diagnosis. There is herein exemplified a case where the fuse of the hydraulic circuit is melted down. Simultaneously, when a pictorial symbol monitor 32 of [HYD] generally representing a hydraulic system is flickered to inform an abnormal condition of the monitor, specific information such as [Yuatsu Huzu] (i.e., Hydraulic Fuse) and the character representation 38 are displayed. The character representation, in which several tens of digits are expressible, runs from right to left, thereby making it possible to surely impart the specific information message.

Note that the battery residual capacity indication is given by means of a level meter consisting of LEDs. The level indication may be effected by and LCD and other similar means instead of employing the LEDs.

FIG. 6 is a flowchart showing the monitor operations in the functional constitution (FIG. 1) based on the microcomputer 15.

The monitor operations will hereinafter be described. To begin with, the key switch KS is turned ON to start the operations. Subsequently, a battery residual capacity is indicated by the level meter (step S1), and there comes a pictorial character display mode for a monitor target (step S2).

The next step is to check whether an internal memory readout mode appears or not. If so, the related data are displayed, and the program is returned (steps S3 and S4). Whereas if not, whether or not the battery residual capacity is E (over discharge) is examined (step S5). If not, the task is to judge whether an abnormal state is present in monitor input data or not (step S6). Subsequent to this step, after turning ON the key switch, an indication of "monitoring OK" is given only for two seconds (steps S7 and S8). Thereafter, the display mode comes to an hour meter representation in the form of management information messages during the normal operation (step S9).

Now, whether the hour meter is in a count mode or not is examined (step S10). If the answer is YES, an on-count state is informed by flashing (flickering) of "HR" of the hour meter (step S11). If No, the hour meter representation is fixed (step S12), the program is return.

If there is an indication E in the step S5, whether or not a hydraulic interlock mode is set during the over-discharge is checked. If YES, the hour meter representation is disappeared. Instead, an indication of [CHARGE] is provided. Whereas if NO, the program is returned directly (steps S13 and S14).

If an abnormality can be seen in the monitor input data in the step S6, a monitor pictorial symbol corresponding to the abnormal component is flashed to display the abnormal state (step S15). Then disappears the hour meter representation. In the character representation 38, a name of the abnormal. part and an abnormal information message are indicated while moving them from right to left (step S16). Repetitions of the operations discussed above enable the driver to surely readily know if the driving condition is normal or abnormal, with the result that the maintenance and management can exactly be carried out.

The above-described embodiment has dealt with examples where the pictorial symbol monitor flickers when the abnormality is present, and the character information message is flow-displayed. The present invention is not, however, limited to these arrangements. For instance, a practical arrangement is that when the abnormal state is perceived, a corresponding pictorial symbol and a non-flowing, viz., fixed information message are displayed.

FIG. 10 is a functional block diagram depicting a system for carrying out the monitor display method of the invention. Turning to FIG. 11, there is illustrated a circuit diagram of a hydraulic circuit and a control circuit of the battery forklift.

The control circuit will now be explained with reference to FIG. 11. (However, the same components as those shown in FIG. 3 are marked with the like symbols).

On receiving a variety of input, the microcomputer 15A controls the actuators such as the hydraulic main circuit 12, the traveling main circuit 13 and the steering main circuit 14 and also has a self-diagnostic function to check whether abnormalities takes place in the parts or equipments in conformity with a predetermined program. The results of self-diagnosis are stored as abnormal part history data in the internal memory thereof, which data are in turn displayed on the display unit 5. Inputted to the microcomputer 15A are signals from an abnormal part history data display change-over means 31, an internal memory fetching step-up input means 32 and an internal memory clear input means 33.

The description will next be focused on the functional constitution based on the microcomputer 15A in conjunction with FIG. 10. The reference numeral 21 designates a battery residual capacity detecting means; 22 an inspection spot monitoring means like the hydraulic main circuit 12; 23 a working time integrating means; 24A judging means for self-diagnosing whether the operations of the foregoing means are normal or abnormal upon receiving monitor signals therefrom and also effecting other judgments; 25 a mode setting means; 26 internal memory data for control; 27 a display driving circuit to which signal are outputted on the basis of the self-diagnostic results given from the judging means 24A; 28 pictorial symbol display data for pictorial-symbol-displaying a variety of monitoring spots which have already been grouped according to every functional component of the battery forklift; 29 a battery residual capacity meter of the display unit 5; 30 a monitor display thereof; 31 an abnormal part history data display change-over means; 32 an internal memory fetching step-up input means; and 33 an internal memory clear input means. The signals transmitted from these means are imparted to the judging means 24A.

Turning to FIGS. 12 and 13, there are shown specific configurational examples of the forgoing means 31 through 33. These are all constructed of input switches packaged in a board of the microcomputer (MPU) 15A. More specifically, a change-over switch 31A depicted in FIG. 12 constitutes the abnormal part history data display change-over means 31; a button switch 32S forms the internal memory fetching step-up input means 32; and a button switch 33S constitutes the internal memory clear input means 33.

A rotary switch RS depicted in FIG. 13 serves as the above-mentioned means 31 to 33. For example, [0] of the rotary switch RS indicates a normal display mode, an abnormal part history data display mode is identified by each of [1] through [E] by which a step-up number is specified. The symbol [F] represents a clear mode.

Where a step-up of the abnormal part history data display is automatized, the button switch 32S may be eliminated. FIGS. 5 and 14 show display examples where the abnormal part history data display mode is set by effecting the display step-up manually or automatically.

The display example of FIG. 5 implies that a fuse of the hydraulic circuit is in an abnormal state.

Namely, the pictorial symbol monitor 32 of [HYD] generally representing the hydraulic system is flickered to inform an abnormality being caused. Simultaneously, a name of the abnormal part, [Yuatsu Huzu] (or Hydraulic Fuse), is indicated as a message in a character representation 38'. The operation of the step-up input means 32 enables the next data to be further displayed. The representations may be performed in the order of the abnormalities being caused or in the reversed order. Thus, the selection thereof may properly be made.

FIG. 14 illustrates a display mode in which parallel 8-bit expression is practicable, viz., an abnormal part name is expressed by codes. This example is based on two step-ups. Referring to FIG. 14, 0 to 7 bits are codes, and the leftmost numeral [2] is a step-up number (corresponding to a page number). In the display mode of FIG. 14, let n be the number of checkup targets, and the step number becomes n/8. The individual bits for every step correspond to the respective components. Active signals of [1] or [H] are given to bits corresponding to the parts which have been judged to be abnormal, while non-active signals of [0] or [L] are imparted to bits corresponding to the normal parts. That is, for instance, at the second step the bits correspond from the low order to [Hydraulic Fuse], [Hydraulic Contactor], [Hydraulic Motor] [Hydraulic Chopper].... In the example of FIG. 14, it follows that the hydraulic fuse and the hydraulic motor to which the bits indicated [1] correspond are judged abnormal.

In accordance with the display mode shown in FIG. 14, the sequence in which the abnormalities take place is not stored. However, since eight parts can be checked up at one time, a checkup time for maintenance and management can be reduced.

The abnormal part history data are cleared by clearing the internal memory, thus reverting an initial state. With this arrangement, it is feasible to confirm abnormality generating conditions for a given period, which in turn effective in obtaining statistical data.

Turning to FIG. 16, there is illustrated circuitry of the hydraulic circuit and the control circuit of the battery forklift (however, the same components as those of FIG. 3 are identified by the like symbols).

The microcomputer 15B receives signals transmitted from an operation input means consisting of a variety of switches, a detecting means composed of sensors provided for the respective components and a feedback means for feeding back the operational conditions of the traveling main circuit 13 and the steering main circuit 14. Immediately, the microcomputer 15B outputs signals for controlling an actuator of a component control unit associated with the hydraulic main circuit 12, the traveling main circuit 13 and the steering main circuit 14. The microcomputer also, as will be stated alter, monitors and checks up an actuator condition, a working time and a voltage of the battery 11, and outputs display signals for causing monitor contents and management information messages to be indicated on the monitor display 30.

Provided upwardly of an MPU board of the microcomputer 15B is a select switch 15A consisting of a rotary switch for selecting the operation modes of the microcomputer in addition to an I/O port for inputting and outputting the foregoing data. A select position of the select switch 15s is, though a detailed description will be given later, arbitrarily changed over, whereby the monitor display 30 is permitted to display the information required.

FIG. 15 is a block diagram showing a functional construction based on the microcomputer 15B. Referring to FIG. 15, the numeral 41 denotes an operation input means composed of operation switches for the respective parts; 42 a detecting means composed of sensors for detecting the operating conditions of the respective parts; 43 a means for outputting feedback signals; 44 an input port for receiving the signals from the above-described means; 45 a processor for effecting predetermined control process upon receiving signals from the input port 44 as well as from the select switch 15S; and 46 an output port for outputting both display signals to the monitor display 30 and control output signals of the above-mentioned component control unit 47.

FIGS. 4 and 5 illustrate specific examples of display modes of the monitor display 30. FIG. 4 shows a display situation in a [normal mode] to indicate general management information messages such as integrated working time (hour meter) information. FIG. 5 illustrates a display situation in an [I/O condition display mode] for inspection and checkup.

The display modes are altered by changing over the select switch 15S. The select switch 15S is selectively set in a position of "0", thereby obtaining the normal mode. When selectively setting the switch 15S in other positions of "1, 2, ...", the I/O condition display mode is selected.

In this I/O condition display mode, there is displayed a data situation of the input port of the number corresponding to the select position (number) of the select switch 15S.

The display unit 5 is constructed of the monitor display 30 using an Lcd and the battery residual capacity meter 29 conceived as a level meter which is composed of a plurality of LEDs. Seven pieces of pictorial symbols 31 through 37 arrayed in a lower line on the display 30 exhibit contents of groups of monitoring spots needed for daily inspections of the electric vehicle and for driving it, these monitoring spots being divided according to every functional components. The character representation 38, which is given in an upper line thereof and consisting of Japanese characters, alphabetic characters and numerals that are formed in dot matrices, exhibits a detailed information message such as a name of the abnormal part for every pictorial symbol when the abnormal state is confirmed from the self-diagnostic results as well as indicating the normal mode and the I/O condition display mode.

FIG. 14 shows the I/O condition display mode in which the select switch 15S is selectively set to "2", and there is illustrated an input data condition of an input port P2 of the MPU board. In this example, [2] represents the input port P2, and [11010101] subsequent to a slash [/] indicates 7 through 0 bit of the input data of the port P2 in the character representation 38. If the data are present, a numeral [1] is displayed. Whereas if not, a numeral [0] is displayed. Note that the control function is invariable irrespective of the select positions for the select switch 15S to thereby obtain the normal operations, and displaying alone differs.

In accordance with the present invention, as stated earlier, when observing an I/O data situation during the normal control, it is enough to adjust a select position (number) of the select switch 15S to a desired port number. Hence, no addition of special parts is required, and it is possible for anyone to simply check up the I/O conditions of the microcomputer.

If an abnormal state is detected from the self-diagnosis, and when, though not illustrated, a fuse of the hydraulic circuit is melted, the pictorial symbol monitor 32 generally representing the hydraulic system is flickered to inform a monitor abnormality. At the same moment, a piece of character information in detail such as [Yuatsu Huze] (or Hydraulic Fuse) is displayed. This character display moves from right to left. In this case, several tens digits are available for the character display to provide a detailed information message.

It is to be noted that a battery residual capacity is displayed by the LED-based level meter, but the levels may be indicated by an LED and other similar means instead of using the LEDs.

FIG. 17 is a flowchart showing the display mode operations in the functional construction (FIG. 16) based on the microcomputer 15B.

The display mode operations will hereinafter be described. The operation starts with reading the operational input data of the operational switches of the respective components, the detection input data of the sensors thereof and the feedback signal data, respectively (steps S17, S18 and S19). Subsequently, control and arithmetic processes are executed in conformity with a predetermined program (Step S20), and control output signals are outputted to the control unit (step S21).

At this time, there is made an examination as to whether or not a select position of the select switch supports an indication of the data contents of output ports Pn (in this embodiment, n is the numerals of 1 to 9 other than 0 and also the letters of A to F) (step S22). If the answer is No, i.e., when the select position is 0 in this example, the general information data display 30 is employed for display in the normal mode (steps S23 and S24). Whereas if YES, the data contents of a register of the I/O port which corresponds to the select position of the select switch are indicated on the display by use of 1 or 0 in the I/O condition display mode (steps S25 and S26). Note that the representation is to limited to 0 and 1 but may adopt characters like L and H and other symbols.

Thus, the I/O conditions of the microcomputer can be checked up with facility by preparing no particular inspection device.

As discussed above, the monitor display method of the invention exhibits the following advantages. The pictorial symbol representations with respect to the groups of monitoring spots which are divided according to every functional component pursuant to the monitor contents are combined with the management information messages expressed in character. The combination thereof permits the management information message to be displayed during the normal operation, and also permit both monitor pictorial symbols and the abnormal information message to be displayed during the abnormal operation. This arrangement in turn makes it practicable to display multi-purposed and multi-functional messages to make an appeal directly to the visual sense. This approach facilitates a quick understanding of the display contents, thereby relieving the burdens on the driver of the electric vehicle in terms of mental fatigues and mental hygiene as well.

Besides, a good deal of information can be displayed in detail with a simple construction, and the monitor information on the spots requiring daily inspections and monitoring of the electric vehicle can accurately be grasped. This in turn yields great effects in which economical advantages are enhanced and both the maintenance and management are facilitated.

The history data about the components deemed to be abnormal may be displayed in the order of the abnormalities being caused or in the reversed order, thereby facilitating the operation of finding out the deteriorated parts in terms of statics while observing the display. It is also feasible to readily comprehend a clue for seeking the true cause. Hence, essential repairing of a fault, and both proper maintenance and management can be attained.

In accordance with the present invention, even when a plurality of abnormal parts are stored, the names thereof can be confirmed at one time. This arrangement leads to a quick maintenance and inspection. The periodic confirmations facilitate grasping of a frequency at which the abnormalities appear in the parts.

Furthermore, pieces of multiple monitor information and management information are shown on the display unit, and the data contents of the I/O port of the microcomputer are displayable as the necessity arises. Therefore, the cause for trouble can immediately exactly be detected if the control unit functions abnormally. The maintenance and inspection of the microcomputer control unit can easily economically be effected with a simple constitution.

Note that the electric vehicle exemplified herein in the form of a batter forklift may include those driven by other energy sources such as a battery DC power supply.

Although the illustrative embodiments have been described in detail with reference to the accompanying drawings, it is to be understood that the present invention is not limited to those precise embodiment. A variety of modifications and changes may be effected therein by one skilled in the art without departing from the scope or spirit of the invention.

## Claims

1. A method of displaying monitor information in a monitor system incorporating a control means and a display unit for effecting monitor-display, concentrating pieces of the monitor information on a plurality of inspecting/monitoring spots at a single place in an electric vehicle, the method comprising the steps of:

dividing a variety of monitoring spots into groups according to every functional component of said electric vehicle;

displaying said groups of said monitoring spots in the form of pictorial symbols on said display unit;

indicating monitor results in said pictorial symbols; and

displaying a management information message in character during a normal operation of said electric vehicle and a detailed abnormal information message in character for every pictorial symbol representation associated with said respective monitoring spots during an abnormal operation thereof.

2. A method of displaying monitor information in a control system having a self-diagnostic function with respect to parts and equipments and incorporating a display unit for displaying self-diagnostic results in an electric vehicle, the method comprising the steps of:

sequentially storing in an internal memory the names of parts or equipments as abnormal part history data which are judges to be abnormal from the self-diagnostic results in the order of the abnormalities being caused;

setting a mode of displaying said abnormal part history data; and

displaying said abnormal part history data on said display unit in the order of the abnormalities being caused or in the reversed order in the form of character messages or codes when setting said mode.

3. A method as claimed in Claim 2, characterized in that: said display unit employed, which is capable of making expressions by a plurality of bits in parallel has a mode of displaying said abnormal part history data; the names of said parts or equipments judged abnormal from the self-diagnostic results are stored in said internal memory; when setting said mode, the individual bits of said display unit are made to correspond to said respective parts; and active signals marked with [1] or [H] with respect to the bits corresponding to said abnormal parts and non-active signals marked with [O] or [L] with respect to the bits corresponding to said normal parts are displayed on said display unit.

4. A method of displaying monitor information in an electric vehicle incorporating both a microcomputer-based control system and a display system for displaying pieces of management information and of monitor information on respective components of said electric vehicle according to outputs of said control system, the method comprising the steps:

permitting said microcomputer to effect an arithmetic operation on the basis of input data upon inputting signals from operation switches and sensors of respective components of said electric vehicle or feedback signals of said respective components;

outputting one of control output signals and display signals;

exhibiting a normal display mode when a selective state of a mode change-over select switch attached to said microcomputer is in a predetermined position;

displaying general information on the control or arithmetic results on a display unit;

exhibiting an I/O condition display mode when the selective state of said select switch is in positions other than said predetermined position; and

displaying on said display unit the data contents, in the form of numerals such as 1 or 0, characters or symbols, of a register of an I/O port of said microcomputer, these contents correspond to the selecting positions.

## FIG. 1

```
┌──────────────────┐  ┌──────────────────┐  ┌──────────────────┐
│ 21               │  │ 22               │  │ 23               │
│ BATTERY WORKING  │  │ INSPECTING/SELF- │  │ WORKING TIME     │
│ CONDITION        │  │ DIAGNOSTIC SPOT  │  │ INTEGRATING      │
│ DETECTING MEANS  │  │ MONITORING MEANS │  │ MEANS            │
└──────────────────┘  └──────────────────┘  └──────────────────┘
         │                    │       │              │
26 ┌──────────────────┐   ┌──────────────┐   ┌──────────────────┐ 25
   │ INTERNAL MEMORY  │◄─►│ JUDGING MEANS│◄──│ MODE SETTING     │
   │ DATA             │   │              │   │ MEANS            │
   └──────────────────┘   └──────────────┘   └──────────────────┘
                         24 │
                    ┌──────────────────┐        ┌──────────────────┐ 28
                    │ 27               │        │ PICTORIAL SYMBOL │
                    │ DISPLAY DRIVING  │◄───────│ DISPLAY DATA     │
                    │ CIRCUIT          │        └──────────────────┘
                    └──────────────────┘
5 ┌───────────────────────────────────────────────────────┐
  │  ┌──────────────────┐ 29   ┌──────────────────┐        │
  │  │ BATTERY RESIDUAL │      │ MONITOR DISPLAY  │        │
  │  │ CAPACITY METER   │  30  │                  │        │
  │  └──────────────────┘      └──────────────────┘        │
  └───────────────────────────────────────────────────────┘
```

## FIG. 2

# FIG. 3

## FIG. 4

BATTERY CAPACITY

F

E

**TOTAL 98765.4HR**

| TRAVEL | HYD | BATT | STEER | OIL | LOAD | BRAKE |
|--------|-----|------|-------|-----|------|-------|

31  32  33  34  35  36  37

## FIG. 5

BATTERY CAPACITY

F

E

**FUSE HYD.**

HYD

32

EP 0 416 171 A2

EP 0 416 171 A2

# FIG. 6

( START ) TURN ON A KEY SWITCH

DISPLAY A BATTERY RESIDUAL CAPACITY ON A LEVEL METER — S1

DISPLAY PICTORIAL CHARACTERS OF A MONITORING TARGET — S2

S3 — MPU INTERNAL MEMORY READOUT MODE?

YES → S4 DISPLAY THE DATA OF MPU INTERNAL MEMORY → (C)

NO → S5 BATTERY RESIDUAL CAPACITY IS DISPLAYED BY E(OVER-DISCHARGED)?

YES → S13 ALARM MODE DURING THE OVER-DISCHARGE?

NO → (C)

YES → S14 [CHARGE] IS DISPLAYED BY DELETING THE HOUR METER DISPLAY → (C)

NO → S6 IS THERE AN ABNORMALITY IN MONITOR INPUT DATA?

YES → S15 ABNORMALITY IS DISPLAYED BY FLASHING THE MONITOR PICTORIAL SYMBOL OF THE ABNORMAL PART → EXTINGUISH THE HOUR METER DISPLAY, AND THE ABNORMAL STATE IS DISPLAYED IN MOVING MESSAGE → (C) S16

NO → S7 ARE 2 SECONDS AVAILABLE AFTER TURNING ON THE KEY SWITCH?

YES → S8 DISPLAY "MONITORING OK"

NO → S9 HOUR METER DISPLAY → S10 HOUR METER COUNT MODE?

NO → S12 FIX THE HOUR METER DISPLAY

YES → S11 ON-COUNT STATE IS DISPLAYED BY FLASHING "HR" OF HOUR METER → (C)

14

## FIG. 7

BATTERY

101

E ⟍⟍ F

## FIG. 8

102

| TVL | HYD | BAT |
|-----|-----|-----|
|  ◻  |  ◻  | ⊟   |

## FIG. 9

103

85

FIG. 10

21 BATTERY WORKING CONDITION DETECTING MEANS

22 INSPECTING / SELF-DIAGNOSTIC SPOT MONITORING MEANS

23 WORKING TIME INTEGRATING MEANS

24 ABNORMAL PART HISTORY DATA DISPLAY CHANGE-OVER MEANS

24A

25 MODE SETTING MEANS

26 INTERNAL MEMORY DATA

27 DISPLAY DRIVING CIRCUIT

28 PICTORICAL SYMBOL DISPLAY DATA

29 BATTERY RESIDUAL CAPACITY METER

30 MONITOR DISPLAY

32 INTERNAL MEMORY FETCHING STEP-UP INPUT MEANS

33 INTERNAL MEMORY CLEAR INPUT MEANS

JUDGING MEANS

5

# FIG. 11

HYDRAULIC MAIN CIRCUIT 12

11

F   Mp   (A)

TRAVELING MAIN CIRCUIT 13

STEERING MAIN CIRCUIT 14

15A   MPU

DISPLAY UNIT 5

HYDRAULIC INPUTS
LIFT
TILT
REACH
16

Mp

TRAVELING INPUT 17

STEERING INPUT 18

OTHER INPUTS 19

31 — ABNORMAL PART HISTORY DATA DISPLAY CHANGE-OVER MEANS

32 — INTERNAL MEMORY FETCHING STEP-UP INPUT MEANS

33 — INTERNAL MEMORY CLEAR INPUT MEANS

## FIG. 12

MPU CIRCUIT — 15A

31S  32S  33S

## FIG. 13

MPU CIRCUIT — 15A

DEF0123456789A — RS

## FIG. 14

29  5  30  38

BATTERY CAPACITY

F

E

2 / 1101 0101

| TRAVEL | HYD | BATT | STEER | OIL | LOAD | BRAKE |
|--------|-----|------|-------|-----|------|-------|

EP 0 416 171 A2

## FIG. 15

41 — OPERATION INPUT MEANS OF COMPONENT OPERATION SWITCHES

42 — DETECTING MEANS OF COMPONENT SENSORS

43 — COMPONENT FEED-BACK SIGNAL MEANS

44 — INPUT PORT

45 — PROCESSOR

46 — OUTPUT PORT

47 — COMPONENT CONTROL UNIT

15S — SELECT SWITCH (SELECT SIGNAL)

30 — MONITOR DISPLAY

## FIG. 16

# FIG. 17

START

READ THE OPERATION INPUT DATA OF COMPONENT OPERATION SWITCHES — S17

READ THE DETECTION INPUT DATA OF COMPONENT SENSORS — S18

READ THE COMPONENT FEEDBACK SIGNAL DATA — S19

CONTROL AND ARITHMETIC PROCESSES — S20

OUTPUT THE CONTROL OUTPUT SIGNAL TO CONTROL UNIT — S21

DOES THE SELECT POSITION OF SELECT SWITCH SUPPORT THE I/O PORT CONTENT DISPLAY? — S22

NO → NORMAL MODE — S23

S24 — DISPLAY THE GENERAL INFORMATION DATA ON DISPLAY UNIT

YES → I/O CONDITION DISPLAY MODE — S25

DISPLAY ON THE DISPLAY UNIT THE I/O PORT REGISTER DATA CONTENT CORRESPONDING TO THE SELECT POSITION OF SELECT SWITCH — S26